(19) Europäisches Patentamt

European Patent Office

Office européen des brevets

(11) Publication number: **0 429 027 B1**

# EUROPEAN PATENT SPECIFICATION

(45) Date of publication of patent specification: **06.04.94** (51) Int. Cl.⁵: **C09J 133/20**, C09J 7/02

(21) Application number: **90121989.9**

(22) Date of filing: **17.11.90**

(54) **Flame retardant adhesive composition and laminates.**

(30) Priority: **20.11.89 US 438043**

(43) Date of publication of application:
**29.05.91 Bulletin 91/22**

(45) Publication of the grant of the patent:
**06.04.94 Bulletin 94/14**

(84) Designated Contracting States:
**CH DE FR GB LI LU**

(56) References cited:
**US-A- 3 728 150**

**PLASDOC - CENTRAL PATENTS INDEX - BA-
SIC ABSTRACTS JOURNAL, no. 8733, LON-
DON, GB; & JP-A-62 153373**

(73) Proprietor: **E.I. DU PONT DE NEMOURS AND
COMPANY
1007 Market Street
Wilmington Delaware 19898(US)**

(72) Inventor: **Dueber, Thomas Eugene
312 Hampton Road
Wilmington, Delaware 19803(US)**

(74) Representative: **von Kreisler, Alek,
Dipl.-Chem. et al
Patentanwälte
von Kreisler-Selting-Werner
Postfach 10 22 41
D-50462 Köln (DE)**

**Description**

This invention relates to a flame retardant adhesive composition. More particularly it relates to an adhesive composition for polyimide films and is useful in the fabrication of solderable flexible circuits.

The flexible circuit industry requires adhesives for polyimide film and metal foils (usually copper) which can withstand elevated temperatures and a variety of harsh solvents and chemicals. During the many preparation and processing steps for circuit manufacture, these solvents and chemicals can cause an adhesive to swell leading to blister formation and/or delamination, which results in reduced circuit yields. The application of heat, such as in soldering, can similarly cause circuit failures.

U.S. -A- 3,822,175, 3,900,662 and 3,728,150 disclose crosslinkable acrylic adhesive compositions for bonding polyimide films. However, increasingly it has become important for the adhesive compositions to be flame retardant. External fire sources or short circuits can cause a flexible circuit to burn if it is not flame retardant.

PLASDOC- CENTRAL PATENT INDEX - BASIC ABSTRACTS JOURNAL and JP-A-62 153 373 disclose water born polymer which contains bromine by 4 to 20 weight percent on solid, composed of water born acrylic copolymer and water soluble epoxy and/or emulsified epoxy resin and antimony pentoxide sol. by 3 to 30 weight percent as solid.

It is known that flame-retardancy can be achieved by the addition of materials such as halogen-containing compounds, antimony oxide, or phosphorous compounds. The addition of these materials, at the level needed to achieve flame retardancy can, however, adversely affect the adhesive or electrical properties of materials used to bond polyimides and metal foils for printed circuit uses. The use of a variety of non-polymeric aromatic compounds and non-crosslinked brominated polymers in hot melt adhesive applications is described in U.S. -A- 4,727,107. For the solderable flexible circuit application, low molecular weight materials in the adhesive composition can cause delamination during contact with the high temperature solder. Generally, such materials can also migrate to the adhesive-copper interface, causing lower adhesion. Brominated polymers can be useful flame retarders, but since these polymers are generally not water soluble, coating solutions are usually made with organic solvent systems. This approach can have the disadvantage that not all the brominated polymers are soluble in the coating solvent and some soluble brominated polymers can mix with the adhesive polymer, raising the modulus to an unacceptable level. This results in brittle materials which again have low peel strength. Photopolymerizable brominated acrylic compositions are described in U.S. -A- 4,278,752 and 4,077,859. These would not be useful in double-sided laminates where light will not penetrate through the copper foil.

Thus, there is a need for a flame-retardant adhesive for polyimide films which has adequate adhesion throughout all subsequent processing steps.

This invention relates to an adhesive coating for polyimide film comprising:
(a) 50-90 % by dry weight of adhesive solids of a latex comprising 90-99 dry weight % copolymer and 1-10 dry weight % crosslinking agent wherein the copolymer comprises (i) 15-50% by weight of the copolymer, of acrylonitrile, methacrylonitrile, or mixtures thereof, (ii) 45-84% by weight of the copolymer, of butyl acrylate, ethyl acrylate, 2-ethylhexyl acrylate, lauryl acrylate, lauryl methacrylate, octyl acrylate, heptyl acrylate, or mixtures thereof, and (iii) 1-10% by weight of the copolymer of methacrylic acid, acrylic acid, itaconic acid, or mixtures thereof,
(b) 10-50% by dry weight of adhesive solids of a crosslinked aromatic brominated or poly-(pentabromobencyl acrylate),
(c) 0-15% by dry weight of adhesive solids of antimony oxide.

In a second aspect this invention relates to a polyimide film or a release support coated with the above adhesive coating.

In a third aspect, this invention relates to a laminate comprising at least one substrate adhered to at least one above-described adhesive coated polyimide film.

The latex comprising copolymer and crosslinking agent, component (a), is described in U.S. -A- 3,728,150 and 3,822,175. A preferred composition uses a copolymer of acrylonitrile/butyl acrylate/methacrylic acid in an approximate 35/60/5 ratio by weight mixed with 5% by dry weight phenol formaldehyde resin as crosslinking agent.

The brominated polymer (b) provides flame retardancy and, at the same time, must also satisfy several other requirements. It must be resistant to attack by ionic impurities and, thereby, be able to maintain good moisture and insulation resistance. It must be reasonably transparent. It must be stable under soldering temperatures and stable to processing chemicals. Further, it must not adversely affect the adhesive properties of component (a), i.e., it must not reduce peel strength to an unacceptable level.

It has been found that all these criteria are satisfied by the use of polymeric brominated compounds which do not react or interact with component (a) such that there is an increase in the Tg of the resulting material. Thus, these polymers can be designated as "substantially non-reactive" A significant increase in Tg makes the adhesive composition too brittle and hence reduces the adhesion. In general, brominated polymeric compounds which do not increase the Tg of the resulting material by more than 5°C are acceptable as a flame retardant component.

Low molecular weight, non-polymeric brominated compounds generally are not acceptable as flame retardants. These materials can migrate to the adhesive-substrate interface, causing lower adhesion. Also, they are less stable under soldering temperatures which can lead to delamination during this step. In contrast, substantially nonreactive polymeric brominated materials have the necessary properties to provide flame retardancy without adversely affecting the other properties of the adhesive.

It is possible for the polymeric brominated materials of the invention to have some small degree of unsaturation remaining or some reactive pendant or end groups and still be substantially nonreactive. The reactive functional groups can allow the brominated materials to react with the crosslinking agent in component (a) during the lamination step. This may actually result in a slight increase in adhesion. However, the brominated materials must not cause a significant increase in the Tg of the resulting adhesive composition.

The polymeric brominated component should have as high a bromine content as possible. With a high bromine content it is possible to use less of component (b) and still achieve adequate flame retardancy. The use of lower amounts of component (b) minimizes further any adverse effects on the adhesive properties. Although aliphatic brominated materials can give flame retardancy, it is preferred to use aromatic brominated polymers i.e., polymers in which the bromine is bonded to an aromatic group, and in particular, crosslinked aromatic brominated polymers. The aromatic polymers have greater stability, particularly at the high temperatures of soldering--around 600°F (316°C). In general, aromatic brominated polymers that have crosslinks that are thermally and hydrolytically as stable as the rest of the brominated polymer can be used in the practice of the invention. Examples of suitable non-crosslinked polymeric brominated materials include poly (pentabromobenzyl acrylate), polydibromophenylene oxide, polymeric tetrabromobisphenol A epoxides. Examples of such crosslinked aromatic brominated polymers include crosslinked homopolymers of tetrabromobisphenol A diacrylates and dimethacrylates, polymeric tetrabromobisphenol A epoxides crosslinked with phenolic resins, poly(pentabromobenzyl acrylate) crosslinked with tetrabromobisphenol A diacrylate, and the like.

The polymeric brominated component should be present in an amount from 10 to 50% by weight of the dry weight of the composition. As discussed above, when the bromine content is high it is possible to use less of that component. The particle size of this component is not particularly critical. Peel strength generally increases with increasing particle sizes, but the particles should be small enough so as not to interfere with the formation of a smooth adhesive film. In general, the polymeric brominated material should have an average particle size of 1 of 10 $\mu$m.

The polymeric brominated material may be added to the adhesive composition in the form of a solid which is then dispersed in the composition, a pre-made aqueous dispersion, or as an aqueous-based latex. The exact form which is used will depend on the nature of the brominated compound. Although not preferred, the brominated compound may be added as a dispersion or solution in suitable organic liquid or mixtures of organic liquids, as described in U.S. -A-3,900,662, as long as the liquid is compatible with the latex component (a).

In order to achieve adequate flame retardancy it is sometimes necessary to add an amount of antimony oxide, component (c), which is known to be a synergistic flame retarder when added to brominated compounds. Preferably, a colloidal dispersion of antimony pentoxide is used. The amount of antimony oxide added depends on the nature of the brominated compound used and the thickness of the polyimide substrate. In general, the more bromine present and the thicker the polyimide substrate, the less antimony oxide that is needed. In most cases, not more than 15 wt% antimony oxide will be used based on the dry weight of the adhesive solids. It is preferred that not more than 10 wt% antimony oxide be used.

The adhesive composition may also contain small amounts of other materials to improve the performance. It has been found that Tg modifying agents, i.e., materials which lower the Tg of the composition, can be added to improve the adhesion of the composition. These Tg modifiers must be of sufficiently low volatility so as not to cause problems such as blister formation from further processing. In general, high rather than low molecular weight Tg modifiers are preferred, such as high molecular weight plasticizers or low Tg high molecular weight latexes. In addition, materials such as dispersants, coalescence aids, coating aids, and the like may be added. Dispersants are generally added with the latex copolymer and may be present in an amount up to 5 wt% based on the dry weight of adhesive solids, preferably 0.1 to 1.0 wt. %.

3

Optionally, the adhesive composition can contain reinforcing and/or extender material so long as these do not interfere with the otherwise desirable properties of the adhesive. Examples of reinforcing and/or filler materials include natural or synthetic fibers such as fiberglass, boron, polyester, polyamide, acrylic, polyaramid, nylon, etc. Woven or nonwoven fabrics made from natural or synthetic fibers such as those mentioned above can also be used. Small amounts of particulate filler materials, such as fumed silica, may be used to stabilize coating dispersions.

The adhesive compositions of the invention may be stored as a latex or dispersion in water. If desired, such aqueous latexes or dispersions can contain thickeeners, such as carboxylic acid containing polyacrylates. Although not preferred, the adhesive can be contained as a dispersion or solution in suitable organic liquid or mixtures of organic liquids. Examples of suitable organic liquids are disclosed in U.S. -A- 3,032,521.

Alternatively, the adhesive may be coated on a release layer or other substrate and stored. The adhesive composition can be prepared in an unsupported form by application to a release substrate such as coated paper or polyester. It can then be stored in roll form. Alternatively, the adhesive composition can be coated directly onto polyimide film or other substrates. By "polyimide film" is meant a layer of polyimide or polyimide that contains reinforcing and/or filler material. Polyimides suitable for use in practicing the invention are disclosed in U.S. -A- 3,179,634, Reinforcing and/or filler materials which may be used include those enumerated as being suitable for the adhesive composition. The thickness of the polyimide film will depend on the final application, however, it is generally from 12,7 to 127 $\mu$m (0.5 to 5.0 mils) thick. It is sometimes desirable to treat the surface of the polyimde film to improve its adhesion. Suitable surface treatments have been described in U.S. -A- 3,821,016, 4,426,253 and 4,725,504.

The adhesive composition can be applied by conventional application procedures such as spraying, printing, brushing, dip coating, roll coating, and the like. The adhesive can be applied in varying thicknesses depending on the desired end use. Greater thicknesses can be achieved by a plurality of coats. Ordinarily, the acrylic adhesive will have a thickness of at least 2,5 $\mu$m (0.1 mil) and should not exceed 508 $\mu$m (20 mils). A preferred thickness is 2,5 to 25,4 $\mu$m (0.1-10 mils) with 12,7 to 7,6 $\mu$m (0.5-3 mils) being especially preferred.

The exposed adhesive surface of the coated substrate can be adhered to another suitable substrate to form a laminate having at least three layers. Suitable substrates include metal and especially metal foils of copper, aluminum, nickel, silver, gold, iron or their alloys; woven and non-woven fabrics made from natural or synthetic fibers such as glass, boron, polyester, polyamide, acrylic; woven and non-woven fabric impregnated with resin such as polyimide, polyamide, epoxy, acrylic; paper of natural or synthetic fibers such as polyaramid paper; and film of polymers such as polyimide, polyamide, polyester, acrylic, epoxy, polyurethane. Preferred substrates include metal, polyimide film, polyaramid paper, woven and nonwoven glass fabric, and polyimide or epoxy impregnated glass fabric. Particularly preferred is a laminate comprising polyimide film, adhesive and copper foil.

Various techniques can be used to join material surfaces using the adhesive compositions of the invention. For example, when the adhesive has been applied as a film to a release support such as polyester film or polymer coated paper, two materials can be joined by applying the exposed layer of the adhesive film to one of the materials, peeling off the substrate support from the adhesive film, thus exposing a second surface of the adhesive, and then laminating the second layer of material to the exposed surface of the adhesive film under pressure and heat sufficient to effect crosslinking of the crosslinking agent in the adhesive film.

On the other hand, when the adhesive composition is applied to a nonrelease support, e.g., a polyimide film, the polyimide film can be joined to a second material such as a printed circuit board or metal foil by laminating the polyimide-coated adhesive film to the second material under heat and pressure sufficient to initiate and effect complete crosslinking of the crosslinking agent.

Standard lamination procedures can be used to make the laminates. These include vacuum bag lamination, press lamination, roll lamination, etc. In each case, the laminates are cured, usually under pressure and typically for 60 minutes at 180°C to suitably crosslink the adhesive.

4

EXAMPLES

Test Procedures

1. Peel Strength: Test IPC-TM-650, method 2.4.9. Revision C.

Test strips 0.5 in (1.27 cm) wide by 9 in (22.9 cm) long of the laminate of coated adhesive and copper foil are conditioned 24 hours at 23 deg C and 50 % relative humidity. A test strip is attached with double-sided tape to a free wheeling rotary drum test fixture (german Wheel). The copper foil end of the laminate, that was partially delaminated before attachment to the wheel, is adhered in the mounting clamp of an Instron, a crosshead autographic-type, power-driven testing machine. After alignment the sample is peeled at a crosshead speed of 2 inches (5.1 cm) /min. The peel strength is determined with at least a 2.25 inch (5.7 cm) peel with the peel strength being the average of the readout over this time. The peel strength is multiplied by 2 to give values of pli.

2. Flame Test: Underwriters Test 94 VTM-0.

A sheet of coated adhesive on polyimide film was cured with a 1 mil (0.0025 cm) thick sheet of Teflon® FEP fluorocarbon film next to the adhesive. The Teflon® film was removed and the samples was cut into 5 strips, 2 in (5.08 cm) wide and 8 in (20.3 cm) long. Each strip was taped to the end of a 0.5 in (1.27 cm) diameter metal rod. The sample cylinder was positioned so that the bottom end of the sample was 0.38 in (0.95 cm) below the top of a 0.75 in (1.90 cm) high blue flame from a Bunsen burner. After 3 seconds observations were made. As soon as the flame extinguished, a second 3-second burn was done.

In order to pass this test the total time the 5 samples burn after removal of the flame must be less than 55 seconds.

3. Chemical Resistance: Test IPC-TM-650, method 2.3.2 Method A.

The peel strength of the immersed portion of each specimen was compared with its associated nonimmersed portion in accordance with the following formula:

$$\frac{\text{Immersed Peel Strength}}{\text{Nonimmersed Peel Strength}} \times 100 = \% \text{ of original}$$

For sequential chemical exposure tests, the lower half of the specimen was immersed for 1 minute in each of the specified chemicals sequentially. After immersion in each chemical, the specimen was rinsed in water for 1 minute, and within 15 to 30 minutes after completion of the exposure, the sample was observed for tackiness, blistering, bubbles, delamination or swelling within the dielectric. The peel strength was tested after 16 to 24 hours and compared to the nonimmersed peel strength as above.

4. Solder Float Test

The copper foil side of a sample was immersed just below the surface of Sn/Pb solder at the temperature indicated. The surface was observed for blisters or delaminations. "Pass" designates samples which showed no visible defects after 2 minutes of exposure. "Fail" designates samples which had defects immediately upon exposure to the solder. A time to fail is given for all other samples.

Example 1

This example illustrates the use of a brominated diacrylate with classified crosslinked particles.

Crosslinked particles of tetrabromobisphenol A diacrylate (Interez® RDX 51027, Radcure Specialities, Inc., Louisville, Kentucky) were prepared by adding to a stirred solution of 5.44 kg of Interez® RDX 51027 in 10.89 kg reagent grade acetone, 54.4 kg of benzoyl peroxide. The air above the solution was purged with nitrogen before heating the solution to 50-53°C with a nitrogen blanket at the top of the reflux condenser. After 2 hours the solution gelled. Stirring was stopped, and the mixture heated for a total of 9 hours at 50°C. At this time 42.4 liters of acetone was added to the solid product, which was broken up with vigorous stirring. The solid was collected by filtration, and vacuum oven dried at 50°C overnight to yield 4.95 kg of a white solid. This was pin milled followed by milling with a Vortec jet mill to yield particles having a volume average particle size of 21 um.

The copolymer latex was prepared as described in U.S. Patent 3,822,175. The copolymer had 59 wt% butyl acrylate, 36 wt% acrylonitrile and 5 wt% methacrylic acid. The crosslinking agent was a phenol formaldehyde resin (Ucar® BRL-1100, Union Carbide, Danbury, CT), at a level of 5.0 dry wt%.

The adhesive composition was prepared by mixing the following ingredients:

| Material | Amount (g) |
|---|---|
| Crosslinked brominated diacrylate air classified to a particle size range of 3 to 20 um | 16.0 |
| Polymer Latex 47.8 solids | 71.07 |
| Ucar® BRL-1100, 66 wt% aqueous solution | 1.4 |
| Antimony pentoxide, 35.8 wt% solids of a colloidal dispersion, pH = 9 (Nyacol® A1530, Nyacol Products, Inc., Ashland, MA) | 5.3 |
| Deionized water | 5.4 |

This mixture was ball milled in a 0.5 pint (237 ml) mill jar that contained 242 g of 0.5 in (1.27 cm) carborundum cylinders for 16 hours. The dispersion was filtered through 0.038 mm (400 mesh) screen. Doctor knife coatings were made directly from this dispersion on 1 mil (0.0025 cm) thick Kapton® HN polyimide film (DuPont Co., Wilmington, DE) with a 7 mil (0.018 cm) doctor knife, dried in a 10°C forced draft oven to an adhesive thickness of 2.1 mils (0.0053 cm). Laminates were made by placing the adhesive coated side of the Kapton® film next to the treated side of 1 ounce/square ft (0.061 g/square cm) roll annealed copper and laminating at 360°F (182°C) for 1 hour at 200 psi (35.7 kg/square cm). The peel strength for samples 0.5 in (1.27 cm) wide was 7.6 pli (1.3 N/mm). The sample passed the 94 VTM-0 flame test.

Example 2

This example illustrates the use of a brominated diacrylate with spherical crosslinked particles.

To prepare the spherical crosslinked brominated diacrylate the following mixture was stirred at 6000 rpm with a Silverson L4 R high speed stirrer:

| Material | Amount (g) |
|---|---|
| 25% aqueous solution of polyacrylic acid (Acrysol® A-3, Rohm & Haas Philadelphia, PA) | 15 |
| Benzoyl peroxide | 2.5 |
| Interez® RDX 51027 dissolved in toluene, 74.9% solids | 90.5 |
| Distilled water | 1425 |

The reaction mixture was immediately heated to 88-90°C. Heating was stopped after 51 minutes. The sample was filtered through a coarse sintered glass filter, and the solid resuspended in 15 ml of deionized water and refiltered. This wash procedure was repeated. The dispersion was determined to be 76.77 wt% solids. The average size particle was 5 um.

An adhesive composition was prepared by mixing the following ingredients:

| Material | Amount (g) |
|---|---|
| Crosslinked spherical particles, 76.8% solids | 41.53 |
| Copolymer Latex of Example 1 47.2% solids | 139.4 |
| 66 wt% aqueous solution of Ucar® BRL-1100 | 8.1 |
| Nyacol® A 1530 35.8% solids, pH = 9.0 | 10.6 |
| Deionized water | 12.9 |

The mixture was stirred with a Gifford-Wood Inc. L11/2-6708EX high speed mixer and filtered through 400 mesh screen. A sample of the adhesive was coated onto Kapton® HN film as described in Example 1 using a 4.6 mil (0.012 cm) doctor knife. The adhesive-coated Kapton® was laminated to copper as in Example 1. The peel strength of 0.5 in (1.27 cm) wide samples of the copper clad laminate was 7.3 pli (1.3 N/mm). The cured adhesive passed the 94 VTM-0 test.

Example 3

This example illustrates the addition of the crosslinked brominated compound as a dispersion containing sub-micron size particles.

A dispersion of the crosslinked brominated diacrylate was prepared by adding over 10 minutes a solution of 50 g of Interez® RDX 51027 in 50 g toluene to a solution of 0.5 g sodium lauryl sulfate in 180 g deionized water that was stirred at medium speed in a Waring blender. After the addition was complete, the material was poured into a round bottom flask fitted with water condensor, nitrogen purge, and mechanical stirrer. The mixture was heated to 50°C for 16 hours with stirring. The dispersion was cooled to room temperature to yield 195.5 g of a 21.3 wt% solids dispersion.

An adhesive composition was prepared by mixing the following ingredients:

| Material | Amount (g) |
|---|---|
| Copolymer latex of Example 1, 46.3 wt% solids | 186.6 |
| Ucar® BRL-1100 | 3.9 |
| Dispersion of crosslinked solid, 21.3 wt% solids | 195.5 |
| Nyacol® A1530 35.8% solids, pH = 9.0 | 27.8 |

The mixture was blended for 10 minutes with a high speed stirrer as in Example 2. The dispersion was coated on Kapton® HN film as in Example 1 with a 5.2 mil (0.013 cm) doctor knife and dried at 125°C. A copper-clad laminate was prepared as in Example 1. The peel strength of 0.5 in (1.27 cm) samples of the copper-clad laminate was 3.9 pli (0.7 N/mm). The cured adhesive passed the 94 VTM-0 test.

Examples 4-6

These examples illustrate the improved thermal stability of uncured adhesives prepared with the crosslinked brominated polymers of the invention.

Adhesive compositions were prepared by mixing the following ingredients:

| Material | Amount (g) Example | | |
|---|---|---|---|
| | 4 | 5 | 6 |
| Copolymer Latex of Example 1, 47.2% solids | 70.0 | 70.0 | 70.0 |
| Non-crosslinked brominated epoxy (Thermoguard® 230, M&T Chemicals Inc., Rahway, NJ) | 11.8 | ---- | ---- |
| Non-crosslinked brominated polyvinylphenol (Lyncur® MB, Maruzen America, Inc., New York, NY) | ---- | 9.9 | ---- |
| Crosslinked brominated diacrylate of Example 1 | ---- | ---- | 11.8 |
| Ucar® BRL-1100, 66 wt% aqueous dispersion | 3.6 | 3.9 | 3.6 |

These mixtures were ball milled as in Example 1, filtered through 400 mesh screen and poured into a doctor knife that was positioned above 2 mil (0.0051 cm) Kapton® HN film that has a web speed of 2.1 ft/min (64 cm/min). The coated Kapton® was dried in a first 1,83m (6-ft) zone with 115°C air impingement on the back side of the Kapton® film and in a second 6-ft zone with 118°C air impingement above the coated adhesive. A 1 mil (0.0025 cm) thick Mylar® polyester cover sheet was laminated at 65°C. The adhesive-coated Kapton® was laminated to 2 ounce/square ft (0.061 g/square cm) roll annealed copper as in Experiment 1. Samples were aged at 50°C as a means to assess aging stability. The peel strength was measured using 0.5 in (1.27 cm) wide samples and the results are given below:

| Example | Time (weeks) | Pli | Peel Strength N/mm |
|---|---|---|---|
| 4 | 0.14 | 5.8 | 1.0 |
| 4 | 1 | 4.9 | 0.9 |
| 4 | 2 | 5.8 | 1.0 |
| 4 | 4 | <1 | <0.2 |
| 5 | 0.14 | <1 | <0.2 |
| 6 | 0.14 | 8.6 | 1.5 |
| 6 | 1 | 7.9 | 1.4 |
| 6 | 2 | 10.6 | 1.9 |
| 6 | 4 | 9.7 | 1.7 |

Example 7

This example illustrates the use of crosslinked polymer from Sartomer® 640, tetrabromobisphenol A diacrylate made by Sartomer Company (West Chester, PA).

A crosslinked, brominated polymer of Sartomer® 640 was prepared by stirring a solution of 100 grams of the diacrylate with 100 grams acetone, 155 grams toluene, 1 gram benzoyl peroxide, under nitrogen at 50°C for 18 hours. The solid product was cooled to room temperature, blended with 300 ml of toluene, filtered, and vacuum oven dried to yield 104 g of a white solid. This was pulverized with a mortar and pestle.

An adhesive composition was prepared by mixing the following ingredients:

| Material | Amount (g) |
|---|---|
| Crosslinked polymer | 13.4 |
| Latex of Example 1, 46.3% solids | 60.1 |
| Ucar® BRL-1100, 66 wt% aqueous solution | 1.3 |
| Nyacol® A1530, 35.8% solids, pH = 9.0 | 9.0 |
| Deionized water | 17.4 |

This composition was ball milled and filtered as in Example 1. The dispersion was coated on 2 mil (0.0051 cm) Kapton® HN film with a 5.2 mil (0.013 cm) doctor knife to a thickness of 1 mil (0.0025 cm) and on a 1 mil (0.0025 cm) Kapton® HN film with a 6.5 mil (0.016 cm) doctor knife to a thickness of 2 mils (0.0051 cm). All coatings were dried in a 125°C forced draft oven for 2 minutes. Samples of the laminate 0.5 in (1.27 cm) wide had a peel strength of 5.7 pli (1.0 N/mm), and the cured adhesive passed the flame test, with the flame extinguished immediately after removal of the flame source.

Examples 8-11

These examples illustrate the improved solder resistance of the adhesive using the crosslinked brominated polymers of the invention.

Adhesive compositions were prepared by mixing the following ingredients:

| Material | Amount (g) | | | |
|---|---|---|---|---|
| | Example | | | |
| | 8 | 9 | 10 | 11 |
| Copolymer Latex of Example 1, 46.3 wt% solids | 3693 | 70.4 | 65.2 | 65.2 |
| Crosslinked brominated polymer of Example 1, 30.6 wt% solids | 2696 | --- | --- | --- |
| Non-crosslinked poly-dibromophenylene oxide (PO-64P, Great Lakes Chem. Corp., West Lafayette, IN) | --- | 8.6 | --- | --- |
| Non-crosslinked Lyncur® MB | --- | --- | 11.1 | --- |
| Non-crosslinked Thermoguard® 230 | --- | --- | --- | 11.1 |
| Ucar® BRL-1100 66 wt% aqueous dispersion | 79.9 | 0.9 | 1.1 | 1.166 |
| Nyacol® A1530 35.8% solids, pH = 9.0 | 550.9 | 8.9 | 8.9 | 8.9 |
| Deionized water | --- | 10.0 | 13.0 | 13.0 |

In Example 8, the crosslinked brominated polymer was dispersed with a high speed disperser. A polymeric dispersant was used at a loading of 4.5 dry weight %. The dispersant used was a 50 wt% solids solution of a copolymer of methyl methacrylate/butyl acrylate/acrylic acid (56/34/10) at pH = 9 from addition of ammonium hydroxide solution. The adhesive mixtures 8-11 were ball milled, filtered and coated as in Example 1. Laminates were made with 1 ounce/square ft (0.061 g/square cm) roll annealed copper as in Example 1. Results of the solder float test are given below:

| Example | Solder Temperature (°C) | | |
|---|---|---|---|
| | 316 | 288 | 160 |
| 8 | pass | pass | pass |
| 9 | 2 sec | pass | pass |
| 10 | fail | 4 sec | pass |
| 11 | fail | pass | pass |

Examples 12 and 13

These examples illustrate the improvement in peel strength with the addition of a plasticizer. Adhesion compositions were prepared as:

| Material | Amount (g) | |
|---|---|---|
| | Example | |
| | 12 | 13 |
| Copolymer latex of Example 1 47.3 wt% solids | 20,968 | --- |
| Copolymer latex of Example 1 45.2 wt% solids | --- | 10.0 |
| Dispersion of Ameribrom FR-1025 49.7 wt% solids (Ameribrom Corp., New York, NY) | 4,724 | --- |
| Dispersion of Ameribrom FR-1025 49.8 wt% solids | --- | 2.23 |
| Nyacol® A1530 35.7 wt% solids, pH = 9.0 | 2,609 | 1.24 |
| Triethyleneglycol diacetate | --- | 0.17 |

The Ameribrom FR-1025 dispersion was prepared by adding to 3,260 g deionized water, a 50 wt% solids solution of the dispersant of Example 8, previously neutralized with dimethylethanol amine, followed by the addition of 3,500 g Ameribrom FR-1025, 5.6 g dimethylethanol amine and a 28 wt% solids solution of Acrysol® SAE 60 (Rohm and Haas Co., Cherry Hill, New Jersey), previously neutralized with ammonium hydroxide. The mixture was milled in a Dyno®-mil KDL Pilot model (Chicago Boiler Co.) six passes at a rate of 18.7 min/gal (4.9 min/liter). The mil contained 1.2 liters of 1-1.2 mm zirconia silicate media.

9

The components were stirred together. Example 13 dispersion was filtered through a 25 micrometer bag filter. Each dispersion was coated on Kapton® HN film as in Example 1 with a 5.2 mil (0.013 cm) doctor knife and dried at 110 deg C for 2 min. Laminates were made with 1 ounce/square ft (0.061 g/square cm) roll annealed copper as in Example 1. Results of the peel strength measurement son 0.5 inch (1.27 cm) wide samples are given below:

| Example | Peel Strength | |
|---|---|---|
| | Pli | N/mm |
| 12 | 7.2 | 1.3 |
| 13 | 11.4 | 2.0 |

The remainder of Example 13 dispersion was pumped through a 30 micrometer polypropylene depth filter, and extrusion die coated at 40 ft/min (12.2 m/min) with a dryer temperature of 250 deg F (121 deg C) on 1 mil (0.0025 cm) thick Kapton® film. Laminates of this coated material, performed the same as the knife coated material, but with slightly lower 0.5 inch (1.27 cm) peel strength of 5.8 pli (1 N/mm).

Example 14

This example illustrates the use of a crosslinked brominated epoxy resin in formulating adhesive compositions of the invention.

To prepare the crosslinked brominated epoxy resin, a mixture of 20 grams Thermoguard® 210 in 100 grams methyl ethyl ketone, 2 grams of 66 wt% solids Ucar® BRL-1100 in water and 1 gram of sodium methoxide was stirred at reflux for 18 hours. The solid was collected by filtration, and washed 2 times with methyl ethyl ketone. The solid was stirred in dilute hydrochloric acid, collected by filtration, washed with water until the washes were pH 7 and then vacuum oven dried.

An adhesive was prepared by mixing the following ingredients:

| Material | Amount (g) |
|---|---|
| Copolymer latex of Example 1, 47.2 wt% solids | 6.4 |
| Crosslinked Thermoguard® 210 | 0.8 |
| Ucar® BRL-1100 66 wt% dispersion | 0.3 |

The adhesive disperion was ball milled, and coated as in Example 1 on 2 mil (0.0051 cm) thick Kapton® HN film with a 10 mil (0.025 cm) doctor knife. The coating was dried in a forced draft oven at 121°C for 5 minutes to yield a coating thickness of 0.6 mil (0.015 cm). Copper-clad laminates were made using the adhesive-coated Kapton® film and 1 ounce/square ft (0.061 g/square cm) roll annealed copper as in Example 1. One sample was exposed to solder at 550°F (287.8 °C) for 5 seconds with the copper just below the molten surface. The results of peel strength tests on 0.5 in (1.27 cm) wide samples are given below:

| Sample | Peel Strength | |
|---|---|---|
| | Pli | N/mm |
| not exposed to solder | 7.0 | 1.2 |
| exposed to solder | 7.5 | 1.3 |

Example 15

This example illustrates the chemical resistance and electrical properties of an adhesive composition of the invention.

An adhesive composition was prepared by mixing the following ingredients:

EP 0 429 027 B1

| Material | Amount (g) |
|---|---|
| Copolymer latex of Example 1, 47.8 wt% solids | 74.0 |
| Crosslinked brominated diacrylate of Example 1 | 16.3 |
| Ucar® BRL-1100, 66 wt% aqueous dispersion | 1.5 |
| Deionized water | 5.4 |

The adhesive dispersion was ball milled as in Example 1. The dispersion was filtered through (100 mesh) 0,15 mm screen. To a 83.5 gram sample of 54.0 wt% solids was added 2.3 grams of the antimony pentoxide dispersion of Example 1. The dispersion was coated and dried as in Examples 4-6. Copper-clad laminates were prepared as in Example 1. The electrical properties are given below:

| Property | Result | Test Method |
|---|---|---|
| Dielectric Strength | 3800 volts/(mil) $25,4 \mu m$ | ASTM-D-149 |
| Resistivity | | |
| Volume | $2.1 \times 10^{16}$ ohms cm | IPC-TM-650 method 2.6.17 |
| Surface | $1.7 \times 10^{15}$ ohms | |
| Moisture and Insulation Resistance | $2 \times 10^{9}$ ohms | IPC-TM-650 method 2.6.3.2 method B |

The results from the chemical resistance tests are given below:

| Chemical | % Peel Strength Retained |
|---|---|
| 2-Propanol | 89 |
| Methylene chloride/Tri-chloroethylene (50/50 v/v) | 128 |
| 2 N HCl | 100 |
| 2 N NaOH | 100 |
| Methyl ethyl ketone | 110 |
| Toluene | 125 |
| Sequential Exposure Methylene chloride 2 N NaOH 2 N Sulfuric Acid | 106 |

11

Example 16

This example illustrates the use of a crosslinked solid of pentabromobenzoacrylate and tetrabromobisphenol A diacrylate in formulating adhesive compositions of the invention.

A solution of a mixture of 90 g pentabromobenzoacrylate (Ameribrom FR-1025), 10 g Interez® RDX 51027, 200 g acetone and 150 g methyl ethyl ketone was stirred at 50°C as 1 g of benzoyl peroxide was added. Nitrogen was bubbled through the solution for 2 minutes, and the solution heated with a 75°C water bath for 5 hours. A white solid had precipitated after 30 minutes of stirring. The reaction mixture was heated 16 hours at 50°C. The solid was collected by filtration after stirring with 102 g of added acetone. The solid was vacuum oven dried at 50°C to yield 53.7 g of a white solid.

An adhesive composition was prepared by mixing the following ingredients:

| Material | Amount (g) |
|---|---|
| Copolymer Latex of Example 1, 47.1 wt% solids | 79.5 |
| Crosslinked brominated solid | 9.0 |
| Ucar® BRL-1100, 66 wt% aqueous dispersion | 0.9 |
| Nyacol® A 1530 35.8 wt% aqueous dispersion | 10.0 |
| Deionized water | 12.4 |

The mixture was ball milled as in Example 1, with the antimony oxide added to the mill jar after the 16 hour mill time. After 5 minutes mixing the dispersion was filtered through (400 mesh) 0,038 mm screen and coated on (1) 1 mil (0.0025 cm) thick Kapton® HN film with a 6.5 mil (0.0165 cm) doctor knife for the flame test and (2) 2 mil (0.0051 cm) thick Kapton® HN film with a 5.2 mil (0.013 cm) doctor knife for the peel test. The coatings were dried in a forced draft 110°C oven for 2 minutes. Copper laminates were made of the adhesive on 0.0051 cm thick Kapton® HN film as in Example 1. The peel strength of 0.5 in (1.27cm) wide samples was 5.7 pli (1.0 N/mm). The sample passed the 94 VTM-0 flame test.

**Claims**

1. An adhesive composition comprising:
   a. 50-90% by weight, based upon the total amount of adhesive dry solids, of a latex comprising 1-10% by dry weight, based upon the latex dry components, of a crosslinking agent and 90-99% by dry weight, based upon the latex dry components, of a copolymer comprising (i) 15-50% by weight, based upon the weight of the copolymer, of acrylonitrile, methacrylonitrile or mixtures thereof, (ii) 45-84% by weight, based upon the weight of the copolymer, of butyl acrylate, ethyl acrylate, 2-ethylhexyl acrylate, lauryl acrylate, lauryl methacrylate, octyl acrylate, heptyl acrylate, or mixtures thereof, and (iii) 1-10% by weight, based upon the weight of the copolymer, of methacrylic acid, acrylic acid, itaconic acid, or mixtures thereof,
   b. 10-50% by weight, based upon the total amount of adhesive dry solids, of a crosslinked aromatic brominated polymer, or poly(pentabromobenzyl acrylate and
   c. 0-15% by weight, based upon the total amount of adhesive dry solids, of antimony oxide.

2. The composition of claim 1 wherein the crosslinked brominated polymer contains aromatic bromine.

3. The composition of claim 1 wherein the aromatic, crosslinked, brominated polymer is selected from the group consisting of crosslinked homopolymers of tetrabromobisphenol A diacrylates and dimethacrylates, polymeric tetrabromobisphenol A epoxides crosslinked with phenolic resins, and poly-(pentabromobenzyl acrylate) crosslinked with tetrabromobisphenol A diacrylate.

4. The composition of claim 3 further comprising a Tg modifier.

5. The composition of claim 4 wherein the copolymer comprises 35% by weight acrylonitrile, 60% by weight butyl acrylate and 5% by weight methacrylic acid.

6. The composition of claim 5 wherein the crosslinking agent comprises 5% by dry weight phenol formaldehyde resin.

**7.** A laminate comprising a layer of the adhesive composition of claim 1 adhered to a substrate.

**8.** The laminate of claim 7 wherein the substrate comprises a release layer.

**9.** The laminate of claim 8 wherein the release layer comprises polyester or paper coated with a release agent.

**10.** The laminate of claim 7 wherein the substrate comprises metal, polyester, polyimide film, polyaramid paper, woven glass fabric, nonwoven glass fabric, polyimide impregnated glass fabric, or epoxy impregnated glass fabric.

**11.** The laminate of claim 10 wherein the substrate comprises polyimide film.

**12.** The laminate of claim 11 further comprising a metal foil adhered to the exposed surface of the adhesive composition layer.

**13.** The laminate of claim 12 wherein the metal foil is copper foil.

**Patentansprüche**

**1.** Klebstoffzusammensetzung umfassend:
a) 50-90 Gew.-%, bezogen auf die Gesamtmenge an trockenen Klebstoff-Feststoffen, eines Latex, umfassend 1-10 % an Trockengewicht - bezogen auf die Latex-Trockenbestandteile - eines Vernetzungsmittels und 90-99% an Trockengewicht, bezogen auf die Latex-Trockenbestandteile, eines Copolymeren umfassend
i) 15-50 Gew.-%, bezogen auf das Gewicht des Copolymeren, Acrylnitril, Methacrylnitril oder Mischungen derselben,
ii) 45-84 Gew.-%, bezogen auf das Gewicht des Copolymeren, Butylacrylat, Ethylacrylat, 2-Ethylhexylacrylat, Laurylacrylat, Laurylmethacrylat, Octylacrylat, Heptylacrylat oder Mischungen derselben und
iii) 1-10 Gew.-%, bezogen auf das Gewicht des Copolymeren, Methacrylsäure, Acrylsäure, Itaconsäure oder deren Mischungen,
b) 10-50 Gew.-%, bezogen auf die Gesamtmenge an trockenen Klebstoff-Feststoffen, eines bromierten, aromatischen, vernetzten Polymeren oder Poly(pentabrombenzylacrylat)s und
c) 0-15 Gew.-%, bezogen auf die Gesamtmenge an trockenen Klebstoff-Feststoffen, Antimonoxid.

**2.** Zusammensetzung nach Anspruch 1, worin das bromierte, vernetzte Polymer aromatisches Brom enthält.

**3.** Zusammensetzung nach Anspruch 1, worin das bromierte, aromatische, vernetzte Polymer ausgewählt ist aus der Gruppe bestehend aus vernetzten Homopolymeren der Tetrabrom-Bisphenol A-diacrylate und -dimethacrylate, polymeren Tetrabrom-Bisphenol A-Epoxiden, die mit Phenolharzen vernetzt sind, und Poly(pentabrombenzylacrylat), das mit Tetrabrom-Bisphenol A-acrylat vernetzt ist.

**4.** Zusammensetzung nach Anspruch 3, die weiterhin ein Tg-Modifizierungsmittel umfaßt.

**5.** Zusammensetzung nach Anspruch 4, worin das Copolymer 35 Gew.-% Acrylnitril, 60 Gew.-% Butylacrylat und 5 Gew.-% Methacrylsäure umfaßt.

**6.** Zusammensetzung nach Anspruch 5 worin das Vernetzungsmittel 5 % an Trockengewicht Formaldehyd-Harz umfaßt.

**7.** Laminat, das eine Schicht einer Klebstoff-Zusammensetzung gemäß Anspruch 1 umfaßt, die an ein Substrat anhaftet.

**8.** Laminat gemäß Anspruch 7, worin das Substrat eine Abziehschicht umfaßt.

13

**9.** Laminat gemäß Anspruch 8, worin die Abziehschicht einen Polyester oder mit einem Abziehmittel beschichtetes Papier umfaßt.

**10.** Laminat gemäß Anspruch 7, worin das Substrat Metall, Polyester, Polyimidfolie, Polyaramid-Papier, Glasgewebe, Glasvlies, mit Polyimid imprägniertes Glasgewebe oder mit Epoxy imprägniertes Glasgewebe umfaßt.

**11.** Laminat gemäß Anspruch 10, worin das Substrat einen Polyimidfilm umfaßt.

**12.** Laminat gemäß Anspruch 11, das weiterhin eine Metallfolie umfaßt, die an der ausgesetzten Oberfläche der Klebstoff-Zusammensetzungsschicht anhaftet.

**13.** Laminat gemäß Anspruch 12, worin die Metallfolie Kupferfolie ist.

**Revendications**

**1.** Une composition adhésive comprenant:
a. de 50 à 90% en poids, exprimés par rapport à la quantité totale de solides adhésifs secs, d'un latex comprenant de 1 à 10% de poids sec, exprimés par rapport aux composants secs du latex, d'un agent de réticulation et de 90 à 99% de poids sec, exprimés par rapport aux composants secs du latex, d'un copolymère comprenant:
i) 15 à 50% en poids, exprimés par rapport au poids du copolymère, d'acrylonitrile, de méthacrylonitrile ou de leurs mélanges;
ii) de 45 à 84% en poids, exprimés par rapport au poids du copolymère, d'acrylate de butyle, d'acrylate d'éthyle, d'acrylate 2-éthylhéxyle, d'acrylate de lauryle, de méthacrylate de lauryle, d'acrylate d'octyle, d'acrylate d'heptyle ou de leurs mélanges; et
iii) de 1 à 10% en poids, exprimés par rapport au poids du copolymère, d'acide méthacrylique, d'acide acrylique, d'acide itaconique ou de leurs mélanges,
b. de 10 à 50% en poids, exprimés par rapport à la quantité totale de solides adhésifs secs, d'un polymère bromé aromatique réticulé ou d'un polypentabromobenzylacrylate, et
c. de 0 à 15% en poids, exprimés par rapport à la quantité totale de solides adhésifs secs, d'oxyde d'antimoine.

**2.** La composition de la revendication 1, dans laquelle le polymère bromé réticulé contient du brome aromatique;

**3.** La composition de la revendication 1, dans laquelle le polymère bromé réticulé aromatique est choisi dans le groupe des homopolymères réticulés de diacrylates et de diméthacrylates de tétrabromobisphénol A, des époxydes de tétrabromobisphénol A polyméres réticulés avec des résines phénoliques, et du poly(pentabromobenzylacrylate) réticulé avec du diacrylate de tétrabromobisphénol A.

**4.** La composition de la revendication 3, comprenant en outre un modificateur de Tg.

**5.** La composition de la revendication 4, dans laquelle le copolymère comporte 35% en poids d'acrylonitrile, 60% en poids de butylacrylate et 5% en poids d'acide méthacrylique.

**6.** La composition de la revendication 5, dans laquelle l'agent de réticulation comporte 5% en poids de résine de phénol formaldéhyde.

**7.** Un stratifié comprenant une couche de la composition adhésive de la revendication 1, collée à un substrat.

**8.** Le stratifié de la revendication 7, dans lequel le substrat comporte une couche de libération.

**9.** Le stratifié de la revendication 8, dans lequel la couche de libération comporte du polyester ou du papier revêtu d'un agent de libération.

14

**10.** Le stratifié de la revendication 7, dans lequel le substrat comprend du métal, du polyester, un film polyimide, du papier polyaramide, du verre textile tissé, du verre textile non tissé, un tissu de verre imprégné de polyimide ou un tissu de verre imprégné d'époxy.

**11.** Le stratifié de la revendication 10, dans lequel le substrat comporte un film polyimide.

**12.** Le stratifié de la revendication 11, comprenant en outre une feuille métallique collée à la surface exposée de la couche de la composition d'adhésif.

**13.** Le stratifié de la revendication 12, dans lequel le feuil métallique est un feuil de cuivre.